# EUROPEAN PATENT SPECIFICATION

(11) **EP 4 242 675 B1**
(45) Date of publication and mention of the grant of the patent: **31.12.2025**
(21) Application number: 23160429.9
(22) Date of filing: 07.03.2023
(51) Int. Cl.: G01R 31/34, B64F 5/60, G01M 15/02

(54) **TESTING DEVICE AND AN UNMANNED AERIAL VEHICLE USING THE SAME**
TESTVORRICHTUNG UND UNBEMANNTES LUFTFAHRZEUG DAMIT
DISPOSITIF DE TEST ET VÉHICULE AÉRIEN SANS PILOTE L'UTILISANT

(30) Priority: 07.03.2022 CN 202220480251 U
(43) Date of publication of application: 13.09.2023
(73) Proprietor: Shanghai Autoflight Co., Ltd., Jinshan District Shanghai 201500 (CN)
(72) Inventor: TIAN, Yu, Shanghai, 201500 (CN)
(74) Representative: MERH-IP Matias Erny Reichl Hoffmann Patentanwälte PartG mbB

(56) References cited:
- CN-A- 110 618 383
- CN-A- 111 693 864
- CN-A- 112 327 159
- CN-U- 214 225 360

## Description

### FIELD OF THE DISCLOSURE

The invention relates to the technical field of unmanned aerial vehicle, in particular to a testing device for an unmanned aerial vehicle.

### BACKGROUND OF THE INVENTION

With the vigorous development of the unmanned aerial vehicle (UAV) industry, UAVs have higher and higher requirements for the safety and reliability of the motor. Therefore, before the motor is applied to the UAV, it is necessary to conduct a simulated aging test on the motor.

In the prior art, a testing device is used to simulate the aging test under the load of the propeller to test the motor. At present, the commonly used testing device includes a support stand and a propeller. The tested motor and the propeller are coaxially arranged, and the tested motor and the propeller are set on the support stand at the same time, and the tested motor is carried by the propeller to rotate to perform the aging test of the tested motor. Due to the large size of the propeller, the height of the support stand of the testing device is increased, resulting in a large space occupation and increased difficulty in propeller installation. At the same time, the high-speed rotation of the propeller causes a lot of noise during the test. CN 112 327 159 A relates to a rotating electrical machine characteristic testing bench. CN 110 618 383 A relates to a servo motor test bench. CN 111 693 864 A relates to a propeller characteristic simulation experimental device. CN 214 225 360 U relates to a motor testing bench.

In order to solve the above problems, it is urgent to provide a testing device for an unmanned aerial vehicle.

### SUMMARY OF THE INVENTION

One purpose of the invention is to provide a testing device in order to achieve the effects of reducing installation size and occupied space, reducing the difficulty of installation during the test process, saving test time and reducing noise.

Another purpose of the invention is to provide an unmanned aerial vehicle resulting from having achieved the effect of improved assembly efficiency of the UAV through the above testing device.

For this purpose, the invention provides a testing device as defined in independent claim 1. It provides the following technical solutions: a testing device, used for testing the performance of a tested motor, which comprises a support stand, and wherein the tested motor can be arranged on the support stand; a simulated motor arranged on the support stand, and the simulated motor is coaxially arranged with the tested motor, and the simulated motor is configured to simulate a load when the tested motor is working. The tested motor drives the simulated motor to rotate at a first speed to detect the performance of the tested motor.

Moreover, the simulated motor can preferably be electrically connected to the tested motor, and the simulated motor can be configured to generate a current during rotation. The current can supply power to the tested motor.

Moreover, the testing device can preferably further comprise a power supply. The simulated motor can be electrically connected to the power supply, and the power supply can be configured to drive the simulated motor to rotate at a second speed to simulate the load of the working process of the tested motor.

Moreover, the simulated motor comprises an installation shaft arranged on the support stand, a stator sleeved on the installation shaft, and a rotor sleeved on the stator, and the rotor is rotatably connected to the installation shaft.

Moreover, the simulated motor can preferably further comprise a bearing disposed between the rotor and the installation shaft.

Moreover, the rotor can preferably be coaxially connected to the tested motor.

Moreover, the testing device can preferably further comprise a shaft coupling arranged between the tested motor and the simulated motor.

Moreover, the testing device can preferably further comprise a power supply electrically connected to the simulated motor. A voltage stabilizer can be arranged between the power supply and the simulated motor.

Moreover, the support stand can preferably comprise a pedestal, a first support stand fixedly arranged on the pedestal, wherein the tested motor can be arranged on the first support stand. There can preferably be a second support stand fixedly arranged on the pedestal, wherein the simulated motor can preferably be arranged on the second support stand.

An unclaimed example helpful for understanding of the invention is an unmanned aerial vehicle, which includes a tested motor, the performance of which has been tested by using the testing device described above.

The beneficial effects of the invention: The invention provides a testing device, which is used for the performance testing of a tested motor. The testing device includes a support stand, the tested motor can be arranged on the support stand. The testing device further includes a simulated motor. The simulated motor is used to replace the propeller. The simulated motor is arranged on the support stand, and the simulated motor is coaxially arranged with the tested motor. The simulated motor can simulate the load when the tested motor is working, and the tested motor can drive the simulated motor to rotate at a first speed to detect the performance of the tested motor. The testing device uses the simulated motor to simulate the parameters of the rotation process of the propeller driven by the tested motor, so that the working condition of the simulated motor is close to that of the propeller, and measures the parameters when the tested motor drives the simulated motor to rotate, thereby performing the aging test. Since the size of the simulated motor is much smaller than that of the propeller, and the diameter of the simulated motor is much smaller than that of the propeller, it is beneficial to reduce the height of the testing device, thereby reducing the space occupied by the testing device, reducing the installation difficulty of the operator, and saving test time.

An unclaimed example helpful for understanding of the invention is an unmanned aerial vehicle resulting from speeding up the assembly efficiency of the unmanned aerial vehicle through the above testing device.

### BRIEF DESCRIPTION OF DRAWINGS

In order to more clearly illustrate the technical solutions in the embodiments of the present invention, the accompanying drawings that are referred to in the description of the embodiments of the present invention will be briefly introduced below. Obviously, the accompanying drawings in the following description are only the illustrations of the present invention. For some embodiments, those of ordinary skill in the art can further obtain other drawings according to the content of the embodiments of the present invention and these drawings without paying creative work.
Figure 1 shows the structure diagram of the testing device provided by the embodiment of the present invention;
Figure 2 shows the block diagram of the testing device provided by the embodiment of the present invention;
Figure 3 shows a structure diagram of the simulated motor provided by the embodiment of the present invention.

In the figures:
100 tested motor; 200 support stand; 210 pedestal; 220 first support stand; 230 second support stand; 300 simulated motor; 310 installation shaft; 320 stator; 330 rotor; 400 power supply; 500 shaft coupling; 600 voltage stabilizer; 700 control system.

### DETAILED DESCRIPTION

Below in conjunction with the accompanying drawings and embodiments the invention is described in further detail. It can be understood that the specific embodiments described here are only used to explain the invention, rather than limit the invention. In addition, it should be noted that, for the convenience of description, only parts of the structures related to the present invention are shown in the drawings but not the whole structures.

In the description of the present invention, unless otherwise clearly stipulated and limited, the terms "connected", "connected" and "fixed" should be understood in a broad sense, for example, it can be a fixed connection, a detachable connection, or a single integrated body, it can be mechanically or electrically connected, it can be directly connected or indirectly connected through an intermediary, and it can be the communication of the internal structure of two components or the interaction relationship between two components. Those of ordinary skill in the art can understand the specific meanings of the above terms in the present invention in specific situations.

In the present invention, unless otherwise clearly specified and limited, a first feature being "on" or "below" a second feature may include direct contact between the first and second features, and may further include the first and second features being in indirect contact with each other such as through another feature between them. Moreover, the first feature being "above" the second feature include that the first feature is directly above and obliquely above the second feature, or simply means that the first feature is horizontally higher than the second feature. The first feature being "below", "beneath" and "under" the second feature include that the first feature is directly below and obliquely below the second feature, or simply means that the first feature has a lower level than the second feature.

In the description of this embodiment, the terms "up", "down", "left", "right" and other orientations or positional relationships are based on the orientations or positional relationships shown in the drawings, and are only for the convenience of description and simplification of operations. It does not indicate or imply that the device or element referred to must have a specific orientation, be constructed and operate in a specific orientation, and therefore should not be construed as limiting the present invention. In addition, the terms "first" and "second" are only used to distinguish in description, and have no special meanings.

With the vigorous development of the UAV industry, UAVs have higher and higher requirements for the safety and reliability of motors, especially for motors equipped with medium and large fixed-wing or compound-wing UAVs, their reliability is even more important. Therefore, before the motor is applied to the UAV, it is necessary to perform an aging test with simulated propeller on the motor. The aging test here specifically needs to test the parameters such as temperature, power and loss degree of the motor during the rotation of the propeller, so as to find faults during the operation.

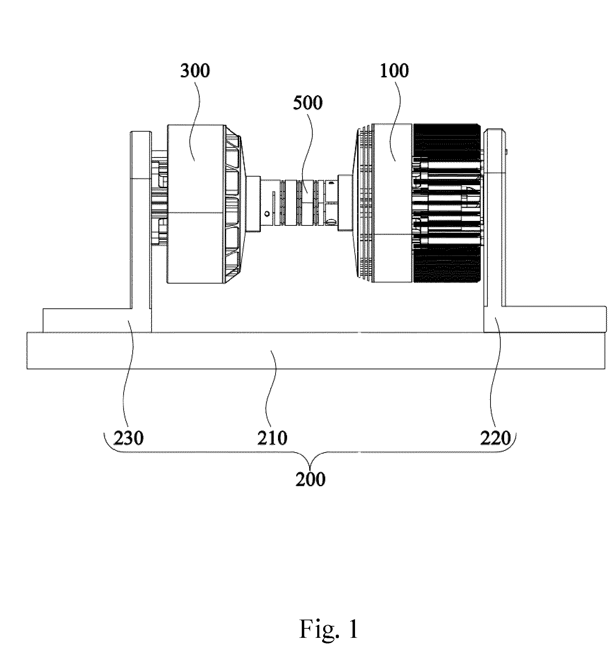

In order to detect the above parameters of the motor, as shown in Figs. 1 to 3, the present embodiment provides a testing device for testing the performance of the tested motor 100. The testing device includes a support stand 200, on which the tested motor 100 is to be arranged.

In the prior art, the commonly used testing device further includes a propeller, the tested motor 100 and the propeller are coaxially arranged, and the tested motor 100 and the propeller are simultaneously arranged on the support stand 200, and the tested motor 100 rotates together with the propeller to perform the aging test of the tested motor 100. Because the diameter of the propeller is too large, the height of the support stand 200 of the testing device increases, resulting in a large space occupation and increased difficulty in propeller installation. At the same time, the high-speed rotation of the propeller causes the resonance of the blade tension and centrifugal force during the test of the testing device, as well as wind noise, which will cause noise when the propeller rotates.

As shown in Fig. 1, in order to solve the above problems, the testing device of the present embodiment further includes a simulated motor 300, and the simulated motor 300 is used to replace the propeller. The simulated motor 300 is arranged on the support stand 200, and the simulated motor 300 is coaxially arranged with the tested motor 100, the simulated motor 300 can simulate the load when the tested motor 100 is working, and the tested motor 100 can drive the simulated motor 300 to rotate at a first speed to detect the performance of the tested motor 100. The testing device uses the simulated motor 300 to simulate the parameters of the rotation process of the propeller driven by the tested motor 100, so that the working condition of the simulated motor 300 is close to that of the propeller, and measures the parameters when the tested motor 100 drives the simulated motor 300 to perform the aging test. Since the size of the simulated motor 300 is greatly reduced compared with the propeller, and the diameter of the simulated motor 300 is much smaller than the propeller, it is beneficial to reduce the height of the testing device thereby reducing the space occupied by the testing device, reducing the installation difficulty of the operator, and thus saving test time. Detecting the parameters of the tested motor 100 by using the testing device is beneficial to improving the assembly efficiency of the UAV.

Specifically, since the tested motor 100 and the simulated motor 300 are small in size, the testing device with this structure only needs to be fixed on a table, which improves the convenience of the test.

As a preferred solution, the simulated motor 300 is electrically connected to the tested motor 100, and the simulated motor 300 generates a magnetoelectric phenomenon during the rotation process driven by the tested motor 100, which can generate current, and the current can supply power to the tested motor 100. Therefore, the power consumption of the tested motor 100 is greatly reduced, which is beneficial to reduce the power loss.

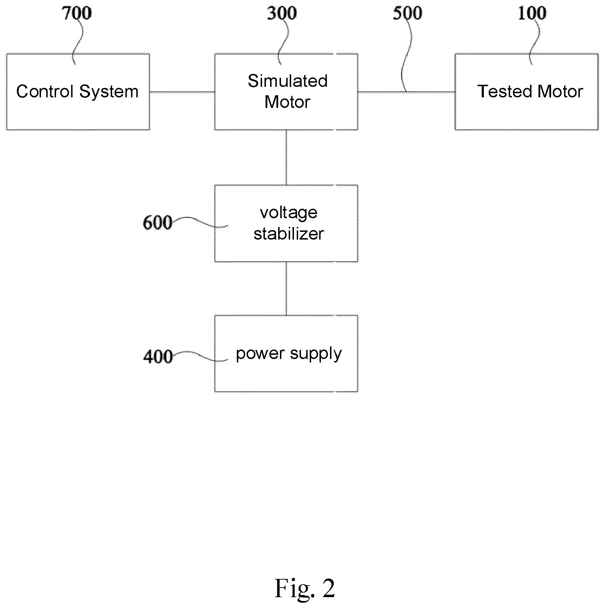

As shown in Fig. 2, the testing device further includes a power supply 400, the simulated motor 300 is electrically connected to the power supply 400, and the power supply 400 can drive the simulated motor 300 to rotate at a second speed to simulate the load of the working process of the tested motor 100. At this time, the simulated motor 300 has the first speed driven by the tested motor 100 and the second speed driven by the power supply 400, and the operator can use the difference between the first speed and the second speed to make the rotation condition of the simulated motor 300 similar to that of the propeller, which is conducive to improving the accuracy of the test results of the testing device.

Furthermore, the second speed is set according to the load parameters in the actual working process of the tested motor 100, so that the simulated motor 300 can simulate the parameters of the rotation process of propellers of different sizes, and the testing device is capable of simulating parameters such as temperature, power and loss degree when the tested motor 100 is equipped with propellers of different sizes, which is beneficial to improve the scope of application of the testing device.

As shown in Fig. 1 and Fig. 2, preferably, the testing device can further include a shaft coupling 500 arranged between the tested motor 100 and the simulated motor 300, and the tested motor 100 and the simulated motor 300 can be horizontally coaxially connected, so as to improve the stability of the connection between the tested motor 100 and the simulated motor 300. Further, a coupling connecting piece can be provided between the tested motor 100 and the shaft coupling 500, so as to improve the stability of the connection between the tested motor 100 and the shaft coupling 500. It can be understood that a coupling connecting piece can be further provided between the simulated motor 300 and the shaft coupling 500.

In order to ensure the stability of the simulated motor 300 in the rotation process, the testing device can further include a voltage stabilizer 600 arranged between the power supply 400 and the simulated motor 300.

Continuing to Fig. 1 and Fig. 2, the support stand 200 can further include a pedestal 210, a first support stand 220 and a second support stand 230. Wherein the first support stand 220 can be fixedly arranged on the pedestal 210, the tested motor 100 can be arranged on the first support stand 220, the second support stand 230 can be fixedly arranged on the pedestal 210, and the simulated motor 300 can be arranged on the second support stand 230. The tested motor 100 and the simulated motor 300 are respectively supported by the first support stand 220 and the second support stand 230 to provide space for the rotation of the tested motor 100 and the simulated motor 300, so as to improve the stability of the testing device. Specifically, the first support stand 220 and the second support stand 230 can be fixed on the pedestal 210 by screws or other fasteners, so as to ensure the stability of the installation of the first support stand 220 and the second support stand 230.

As shown in Fig. 2, it can be understood that the testing device can further include a control system 700, the control system 700 is electrically connected to the tested motor 100 and the simulated motor 300. The load parameters in the actual working process of the tested motor 100 is set in the control system 700, and control system 700 can use the load parameters to make the simulated motor 300 to rotate at the corresponding second speed during the working process of the tested motor 100. At the same time, the control system 700 can record the test results of the tested motor 100.

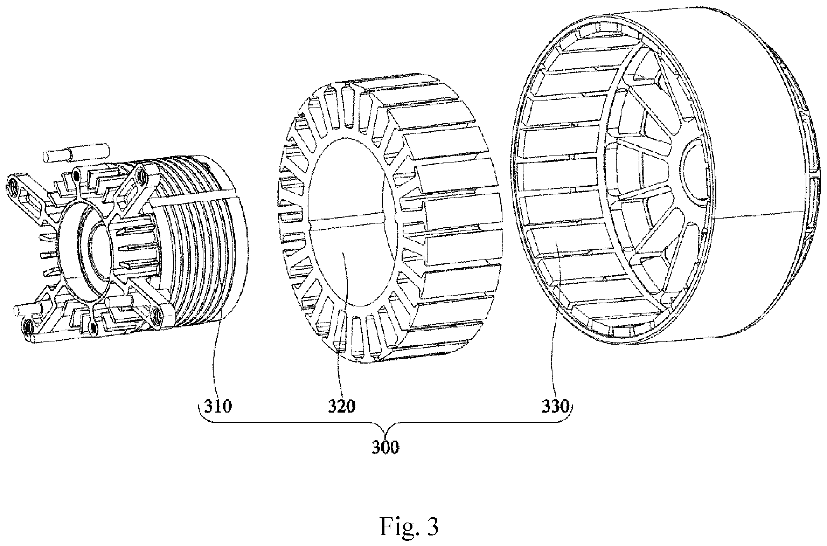

As shown in Fig. 3, specifically, the simulated motor 300 includes an installation shaft 310, a stator 320 and a rotor 330. Wherein, the installation shaft 310 is arranged on the support stand 200, the stator 320 is sleeved on the installation shaft 310, the rotor 330 is sleeved on the stator 320, and the rotor 330 is rotatably connected to the installation shaft 310, so that the rotor 330 can rotate and simulate the propeller.

Exemplarily, the stator 320 can include a wire coil, and the wire coil is connected to the power supply 400 to generate a magnetic field. The rotor 330 can be made of magnetic steel. Under the influence of the magnetic field of the stator 320, the rotor 330 can rotate accordingly, and the rotation speed is related to the input parameters of the power supply 400. It can be understood that the magnetic steel will generate current during the rotation process under the influence of the magnetic field, and the current is electrically connected to the tested motor 100, thereby reducing the power consumption of the tested motor 100, which is beneficial to reduce the power loss.

Further, the simulated motor 300 further includes bearings, which can be arranged between the rotor 330 and the installation shaft 310, so as to avoid rigid friction between the rotor 330 and the installation shaft 310, which can improve the working life of the rotor 330 and the installation shaft 310.

More specifically, the rotor 330 of the simulated motor 300 can be coaxially connected to the tested motor 100. When the tested motor 100 rotates, the rotor 330 can rotate with the tested motor 100 at the first speed to improve the accuracy of the test results of the testing device.

Note that the basic principles and main features of the present invention and the advantages of the present invention are shown and described above. Those skilled in the art should understand that the invention is not limited by the above-mentioned embodiments. The above-mentioned embodiments and descriptions only illustrate the principles of the invention. Without departing from the scope of the invention, the new model further has various changes and improvements, and these changes and improvements all fall within the scope of the claimed invention, and the claimed scope of the invention is defined by the appended claims.

## Claims

1. A testing device to test the performance of a tested motor (100), the testing device comprising:
a support stand (200), wherein the tested motor (100) can be arranged on the support stand (200);
a simulated motor (300) arranged on the support stand (200), and the simulated motor (300) is coaxially arranged with the tested motor (100),
wherein the simulated motor (300) is configured to simulate a load when the tested motor (100) is driving the simulated motor (300) to rotate at a first speed,
**characterized in that**,
the simulated motor (300) comprises:
an installation shaft (310) arranged on the support stand (200);
a stator (320) sleeved on the installation shaft (310); and
a rotor (330) sleeved on the stator (320),
wherein the rotor (330) is rotatably connected to the installation shaft (310).

2. The testing device according to claim 1, wherein the simulated motor (300) is electrically connected to the tested motor (100), wherein the simulated motor (300) is configured to generate a current during rotation, and wherein the current supplies power to the tested motor (100).

3. The testing device according to claim 1, further comprising a power supply (400), the simulated motor (300) is electrically connected to the power supply (400), and the power supply (400) is configured to drive the simulated motor (300) to rotate at a second speed to simulate the load.

4. The testing device according to claim 1, wherein the simulated motor (300) further comprises a bearing disposed between the rotor (330) and the installation shaft (310).

5. The testing device according to any one of the preceding claims, wherein the rotor (330) is coaxially connected to the tested motor (100).

6. The testing device according to claim 1, further comprising a shaft coupling (500) arranged between the tested motor (100) and the simulated motor (300).

7. The testing device according to claim 1, further comprising a power supply (400) electrically connected to the simulated motor (300) and a voltage stabilizer (600) arranged between the power supply (400) and the simulated motor (300).

8. The testing device according to claim 1, wherein the support stand (200) comprises:
a pedestal (210);
a first support stand (220) fixedly arranged on the pedestal (210);
wherein the tested motor (100) is arranged on the first support stand (220);
a second support stand (230) fixedly arranged on the pedestal (210); and
wherein the simulated motor (300) is arranged on the second support stand (230).

## Patentansprüche

1. Testvorrichtung zum Testen der Leistung eines getesteten Motors (100), wobei die Testvorrichtung Folgendes umfasst:
einen Stützständer (200), wobei der getestete Motor (100) auf dem Stützständer (200) angeordnet werden kann;
einen simulierten Motor (300), der auf dem Stützständer (200) angeordnet ist, und wobei der simulierte Motor (300) koaxial mit dem getesteten Motor (100) angeordnet ist,
wobei der simulierte Motor (300) konfiguriert ist, um eine Last zu simulieren, wenn der getestete Motor (100) den simulierten Motor (300) antreibt, um sich mit einer ersten Drehzahl zu drehen,
**dadurch gekennzeichnet, dass**
der simulierte Motor (300) Folgendes umfasst:
eine Installationswelle (310), die auf dem Stützständer (200) angeordnet ist;
einen Stator (320), der auf die Installationswelle (310) aufgeschoben ist; und
einen Rotor (330), der auf den Stator (320) aufgeschoben ist,
wobei der Rotor (330) drehbar mit der Installationswelle (310) verbunden ist.

2. Testvorrichtung nach Anspruch **1,** wobei der simulierte Motor (300) elektrisch mit dem getesteten Motor (100) verbunden ist, wobei der simulierte Motor (300) konfiguriert ist, um während der Drehung einen Strom zu erzeugen, und wobei der Strom den getesteten Motor (100) mit Strom versorgt.

3. Testvorrichtung nach Anspruch **1,** ferner umfassend eine Stromversorgung (400), wobei der simulierte Motor (300) elektrisch mit der Stromversorgung (400) verbunden ist und die Stromversorgung (400) konfiguriert ist, um den simulierten Motor (300) anzutreiben, um sich mit einer zweiten Drehzahl zu drehen, um die Last zu simulieren.

4. Testvorrichtung nach Anspruch 1, wobei der simulierte Motor (300) ferner ein Lager umfasst, das zwischen dem Rotor (330) und der Installationswelle (310) angeordnet ist.

5. Testvorrichtung nach einem der vorhergehenden Ansprüche, wobei der Rotor (330) koaxial mit dem getesteten Motor (100) verbunden ist.

6. Testvorrichtung nach Anspruch **1,** ferner umfassend eine Wellenkupplung (500), die zwischen dem getesteten Motor (100) und dem simulierten Motor (300) angeordnet ist.

7. Testvorrichtung nach Anspruch 1, ferner umfassend eine Stromversorgung (400), die elektrisch mit dem simulierten Motor (300) verbunden ist, und einen Spannungsstabilisator (600), der zwischen der Stromversorgung (400) und dem simulierten Motor (300) angeordnet ist.

8. Testvorrichtung nach Anspruch 1, wobei der Stützständer (200) Folgendes umfasst:
einen Sockel (210);
einen ersten Stützständer (220), der fest auf dem Sockel (210) angeordnet ist;
wobei der getestete Motor (100) auf dem ersten Stützständer (220) angeordnet ist;
einen zweiten Stützständer (230), der fest auf dem Sockel (210) angeordnet ist; und
wobei der simulierte Motor (300) auf dem zweiten Stützständer (230) angeordnet ist.

## Revendications

1. Dispositif de test pour tester les performances d'un moteur testé (100), le dispositif de test comprenant :
un socle de support (200), dans lequel le moteur testé (100) peut être agencé sur le socle de support (200) ;
un moteur simulé (300) agencé sur le socle de support (200), et le moteur simulé (300) est agencé de manière coaxiale avec le moteur testé (100),
dans lequel le moteur simulé (300) est configuré pour simuler une charge lorsque le moteur testé (100) entraîne le moteur simulé (300) pour qu'il tourne à une première vitesse,
**caractérisé en ce que**,
le moteur simulé (300) comprend :
un arbre d'installation (310) agencé sur le socle de support (200) ;
un stator (320) emmanché sur l'arbre d'installation (310) ; et
un rotor (330) emmanché sur le stator (320),
dans lequel le rotor (330) est relié de manière rotative à l'arbre d'installation (310).

2. Dispositif de test selon la revendication 1, dans lequel le moteur simulé (300) est relié électriquement au moteur testé (100), dans lequel le moteur simulé (300) est configuré pour générer un courant pendant la rotation, et dans lequel le courant alimente le moteur testé (100).

3. Dispositif de test selon la revendication 1, comprenant en outre une alimentation électrique (400), le moteur simulé (300) est relié électriquement à l'alimentation électrique (400), et l'alimentation électrique (400) est configurée pour entraîner le moteur simulé (300) pour qu'il tourne à une seconde vitesse pour simuler la charge.

4. Dispositif de test selon la revendication 1, dans lequel le moteur simulé (300) comprend en outre un palier disposé entre le rotor (330) et l'arbre d'installation (310).

5. Dispositif de test selon l'une quelconque des revendications précédentes, dans lequel le rotor (330) est relié de manière coaxiale au moteur testé (100).

6. Dispositif de test selon la revendication 1, comprenant en outre un accouplement d'arbre (500) agencé entre le moteur testé (100) et le moteur simulé (300).

7. Dispositif de test selon la revendication 1, comprenant en outre une alimentation électrique (400) reliée électriquement au moteur simulé (300) et un stabilisateur de tension (600) agencé entre l'alimentation électrique (400) et le moteur simulé (300).

8. Dispositif de test selon la revendication 1, dans lequel le socle de support (200) comprend :
un socle (210) ;
un premier socle de support (220) agencé de manière fixe sur le socle (210) ;
dans lequel le moteur testé (100) est agencé sur le premier socle de support (220) ;
un second socle de support (230) agencé de manière fixe sur le socle (210) ; et
dans lequel le moteur simulé (300) est agencé sur le second socle de support (230).
